# EUROPEAN PATENT APPLICATION

(11) **EP 2 221 967 A1**
(43) Date of publication of application: **25.08.2010**
(21) Application number: 10153948.4
(22) Date of filing: 18.02.2010
(51) Int. Cl.: H03J 5/24

(54) **High frequency apparatus**

(30) Priority: 20.02.2009 JP 2009037797
(71) Applicant: Alps Electric Co., Ltd., Tokyo 145-8501 (JP)
(72) Inventor: Yamamoto, Masaki, Tokyo Tokyo 145-8501 (JP)
(74) Representative: Klunker . Schmitt-Nilson . Hirsch

(57) **Abstract**

Provided is a high frequency apparatus including a first high frequency circuit (23) receiving a power supply voltage and having a high frequency signal output terminal, a second high frequency circuit (25, 27) connected to the high frequency signal output terminal and having first and second switch terminals to perform switching to a first or a second operation mode according to a connection state of the first and second switch terminals, a switch circuit interposed between the first high frequency circuit (23) and the second high frequency circuit (25, 27) to switch the connection state of the first and second switch terminals, and a control circuit applying a control signal to the switch circuit. The switch circuit includes a first switching device (57) and a second switching device (56).

## Description

The present invention claims the benefit of Japanese Patent Application JP 2009-037797 filed in the Japanese Patent Office on February 20, 2009, the entire content of which is incorporated herein by reference.

### BACKGROUND

### 1. Technical Field

The present invention relates to a high frequency apparatus capable of performing a band switching operation by switching a terminal connection state of a SAW filter input section.

### 2. Related Art

In a television receiver, in order to reduce disturbance by an adjacent frequency, a SAW (Surface Acoustic Wave) filter is connected to a rear-stage of an intermediate frequency signal amplification circuit that amplifies an intermediate frequency signal supplied from a tuner. In a television receiver capable of receiving both terrestrial digital broadcasting and analog broadcasting is provided with a digital SAW filter compatible with a digital broadcasting signal and an analog SAW filter compatible with an analog broadcasting signal.

However, when designing a television receiver compatible with Japanese and European television broadcasting schemes, it is necessary to allow the television receiver to be compatible with television broadcasting schemes of each country. The television broadcasting schemes of each country include PAL/B schemes, PAL/G schemes, PAL/D schemes, PAL/K schemes, NTSC/M schemes, NTSC/N schemes, SECAM/L schemes and the like. In particular, according to a SECAM/L scheme employed in France, in relation to four channels treated as a VHF low band, frequencies of an image signal carrier and a sound signal carrier are inverted to each other as compared with those in other VHF low band channels, VHF high band channels and UHF channels.

In this regard, as an analog SAW filter, a SAW filter for an image is provided separately from a SAW filter for sound. Further, the SAW filter for sound is configured to switch a band according to the SECAM/L scheme.

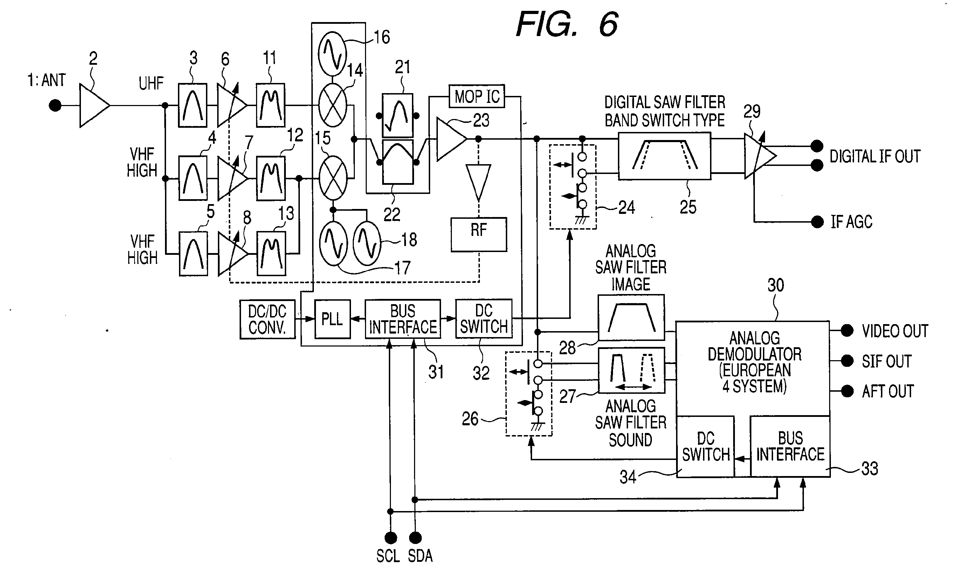

Fig. 6 is a diagram illustrating the configuration of the television receiver compatible with an analog scheme and a digital scheme. In the television receiver illustrated in Fig. 6, after television signals received in a tuner 1 are amplified by a high frequency amplifier 2, reception signals of a UHF band pass through a band-pass filter (BPF) 3, and reception signals of a VHF band pass through two BPFs 4 and 5. The reception signals having passed through the BPFs 3 to 5 are gain-controlled by gain control amplifiers 6 to 8, and then are input to corresponding mixers 14 and 15 through RF filters 11 to 13. Oscillation circuits 16 to 18 are connected to the mixers 14 and 15 to output local oscillation signals corresponding to reception bands. Two band limit circuits 21 and 22 are connected in a switchable manner to a rear-stage of the mixers 14 and 15. The band limit circuit 21 performs band limitation of a narrow band compatible with a digital scheme and the band limit circuit 22 performs band limitation of a wide band compatible with a PAL scheme. The signals having passed through the band limit circuits 21 and 22 are amplified by an intermediate frequency amplifier 23 to a predetermined signal level, and then are input to a digital SAW filter 25 and analog SAW filters 27 and 28. A gain control amplifier 29 is connected to an output stage of the digital SAW filter 25.

Herein, the digital SAW filter 25 is configured to perform a switching operation in limited bands of VHF and UHF. A band switching instruction is supplied to the digital SAW filter 25 from a switch circuit 24. Similarly to this, the analog SAW filter 27 for sound is configured to switch bands according to a SECAM/L scheme. A band switching instruction is supplied to the analog SAW filter 27 for sound from a switch circuit 26. In relation to the switch circuit 24 provided with respect to the digital SAW filter 25, a control signal supplied to a bus interface 31 from a host is converted to an ON/OFF signal by a DC switch 32, and then is supplied to the switch circuit 24. Further, in relation to the switch circuit 26 provided with respect to the analog SAW filter 27 for sound, a control signal supplied to a bus interface 33, which is provided in an analog demodulator 30, from the host is converted to an ON/OFF signal by a DC switch 34 provided in the analog demodulator 30, and then is supplied to the switch circuit 26.

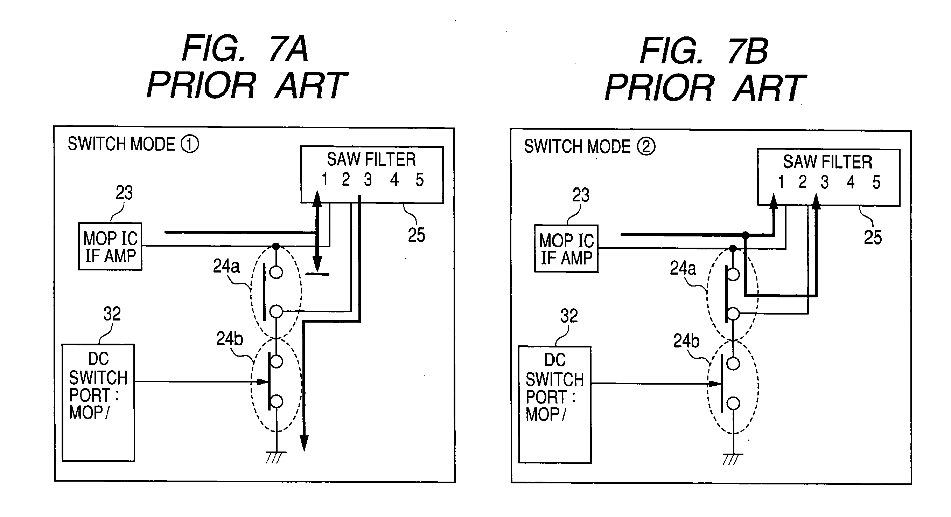

A band switching operation in the digital SAW filter 25 will be described with reference to Figs. 7A and 7B. If a second terminal of the digital SAW filter 25 is grounded, a first band is set. If a first terminal and the second terminal of the digital SAW filter 25 are short-circuited, a second band is set. The switch circuit 24 includes a switch 24b that grounds only the second terminal and a switch 24a that short-circuits the first and second terminals. As illustrated in Fig. 7A, only the switch 24b is switched on by an ON/OFF signal supplied to the switches 24a and 24b from the DC switch 32, so that the first band is set. As illustrated in Fig. 7B, only the switch 24a is switched on, so that the second band is set. The switch circuit 26 provided with respect to the analog SAW filter 27 for sound has a configuration similar to that of the switch circuit 24, and the first band and the second band can be set in the analog SAW filter 27 for sound.

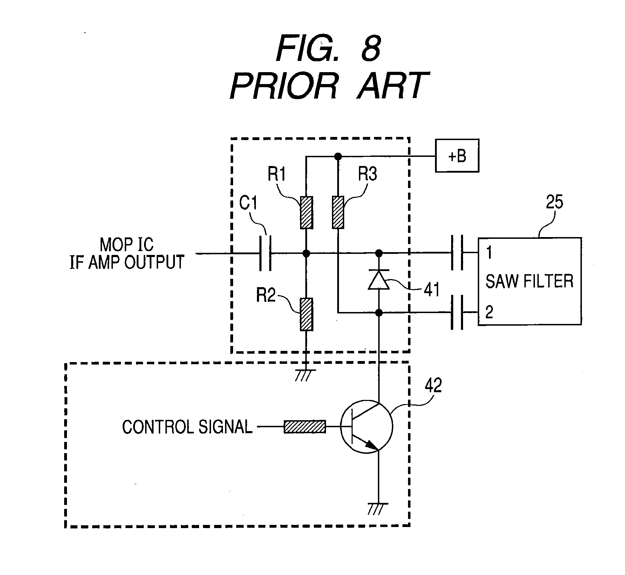

Fig. 8 is a circuit diagram illustrating the circuit configuration of the switch circuit 24. An output terminal of the intermediate frequency amplifier 23 is connected to a first terminal (first pin) of the digital SAW filter 25, and a diode 41 serving as a switching device is connected between the first terminal and a second terminal (second pin). A fixed bias divided by bias resistors R1 and R2 is applied to a cathode of the diode 41, and a predetermined voltage is applied to an anode of the diode 41 through a switching resistor R3. Further, the anode of the diode 41 is connected to the ground through a collector-emitter of a transistor 42. A control signal (ON/OFF signal) is applied to a base of the transistor 42 from the DC switch 32, so that a connection state of the first and second terminals is switched. Since the voltage difference occurs between the fixed bias (e.g., 1.6V) generated by the bias resistors R1 and R2 and an output voltage (e.g., 2.1V) of the intermediate frequency amplifier 23, the output terminal of the intermediate frequency amplifier 23 is connected to the cathode of the switching diode 41 through a DC cut capacitor C1. If the transistor 42 is turned on (conductive), since the second terminal is grounded through the collector-emitter of the transistor 42 and the diode 41 is turned off (not conductive), only the first terminal is connected to the output terminal of the intermediate frequency amplifier 23 in a high frequency manner. Further, if the transistor 42 is turned off (not conductive), since the diode 41 is turned on (conductive), the first and second terminals are short-circuited.

The switch circuit 26 having a configuration similar to that of the switch circuit 24 illustrated in Fig. 8 is provided with respect to the analog SAW filter 27 for sound. The switch circuit 26 receives the control signal from the DC switch 34 provided in the analog demodulator 30 to switch the connection state of the first and second terminals of the analog SAW filter 27 for sound (for example, refer to Japanese Unexamined Patent Application Publication No. 2008-028978).

### SUMMARY

However, in the above-described high frequency apparatus including the two switch circuits, since a plurality of elements for realizing the functions of the switch circuits 24 and 26 are necessary as illustrated in Fig. 8, it is difficult to reduce the circuit size. Further, since the switch circuit with respect to the digital SAW filter and the switch circuit with respect to the analog SAW filter for sound are controlled by separate control systems, the control systems are complicated.

An advantage of some aspects of the invention is to provide a high frequency apparatus in which the circuit size of a switch circuit can be reduced and a control system can be simplified through unification thereof.

According to an aspect of the invention, there is provided a high frequency apparatus including: a first high frequency circuit receiving a power supply voltage and having a high frequency signal output terminal; a second high frequency circuit connected to the high frequency signal output terminal and having first and second switch terminals to perform switching to a first or a second operation mode according to a connection state of the first and second switch terminals; a switch circuit interposed between the first high frequency circuit and the second high frequency circuit to switch the connection state of the first and second switch terminals; and a control circuit applying a control signal to the switch circuit, wherein the switch circuit includes: a first switching device having a control signal input terminal receiving the control signal, a ground terminal connected to a ground, and an output terminal connected to a supply terminal of the power supply voltage through a resistor, and switching on/off between the output terminal and the ground terminal; and a second switching device having one end connected to the output terminal of the first switching device and switching on/off between both ends of the second switching device, wherein a constant voltage for switching on or off the first and second switching devices is output from the high frequency signal output terminal, and the other end of the second switching device is connected to the high frequency signal output terminal in a direct-current manner.

With such a configuration, the constant voltage for switching on or off the first and second switching devices is output from the high frequency signal output terminal, and the other end of the second switching device is connected to the high frequency signal output terminal in the direct-current manner, so that an output circuit of the first high frequency circuit serves as a DC bias circuit of the second switching device. Thus, differently from the related art in which the potential difference occurs in the output voltage of an intermediate frequency amplifier and a fixed bias by resistors of a fixed bias circuit, dedicated DC bias circuits provided for each of the second high frequency circuits can be unified, so that the number of switches can be reduced.

Further, according to an embodiment of the high frequency apparatus of the invention, the first switch terminal is connected to the other end of the second switching device, the second switch terminal is connected to the output terminal of the first switching device, the second switching device is switched off when the first switching device is switched on, and the second switching device is switched on when the first switching device is switched off.

Further, according to an embodiment of the high frequency apparatus of the invention, an output stage of the first high frequency circuit includes two transistors serially connected to the supply terminal of the power supply voltage and a ground, and the high frequency signal output terminal is connected to a connection point of the two transistors.

Further, according to an embodiment of the high frequency apparatus of the invention, the second high frequency circuit is a SAW filter circuit which is in a first operation mode set to a first band characteristics when the first and second switch terminals are opened and the second switch terminal is grounded, and is in a second operation mode set to a second band characteristics different from the first band characteristics when the first and second switch terminals are short-circuited and the second switch terminal is opened with respect to the ground.

Further, according to an embodiment of the high frequency apparatus of the invention, the first high frequency circuit and the switch circuit are formed in a single integrated circuit. Consequently, since the first high frequency circuit and the switch circuit are formed in the single integrated circuit, the interconnection work can be completed by merely connecting the switch terminal of the second high frequency circuit to the output terminal of an integrated circuit. Further, as compared with the related art, the number of work steps can be significantly reduced, and soldering places can be reduced, thereby achieving the improvement of reliability.

### BRIEF DESCRIPTION OF THE DRAWINGS

Fig. 1 is a circuit diagram mainly illustrating the circuit configuration for band switching of a digital SAW filter and an analog SAW filter for sound according to one embodiment.
Figs. 2A and 2B are diagrams illustrating an operation example of band switching of a digital SAW filter and an analog SAW filter for sound according to one embodiment.
Fig. 3A is a diagram illustrating a terminal configuration and a ground state of a digital SAW filter.
Fig. 3B is a graph illustrating the band characteristics of a digital SAW filter in a ground state illustrated in Fig. 3A.

Fig. 3C is a diagram illustrating a terminal configuration and another ground state of a digital SAW filter.
Fig. 3D is a graph illustrating the band characteristics of a digital SAW filter in a ground state illustrated in Fig. 3C.
Fig. 4A is a diagram illustrating a terminal configuration and a ground state of an analog SAW filter for sound.
Fig. 4B is a graph illustrating the band characteristics of an analog SAW filter for sound in a ground state illustrated in Fig. 4A.
Fig. 4C is a diagram illustrating a terminal configuration and another ground state of an analog SAW filter for sound.
Fig. 4D is a graph illustrating the band characteristics of an analog SAW filter for sound in a ground state illustrated in Fig. 4C.
Fig. 5 is a circuit diagram illustrating the configuration of the rear-stage of an intermediate frequency amplifier in a television receiver according to a modification of the invention.
Fig. 6 is a diagram illustrating the configuration of a television receiver compatible with an analog scheme and a digital scheme.
Figs. 7A and 7B are graphs illustrating an operation example of band switching of a digital SAW filter according to the related art.
Fig. 8 is a circuit diagram illustrating the circuit configuration of a switch circuit of a SAW filter input section according to the related art.

### DESCRIPTION OF EXEMPLARY EMBODIMENTS

An embodiment of the invention will be described in detail with reference to the accompanying drawings.

A television receiver according to the embodiment of the invention is achieved by modifying the circuit configuration for band switching of a digital SAW filter and an analog SAW filter for sound.

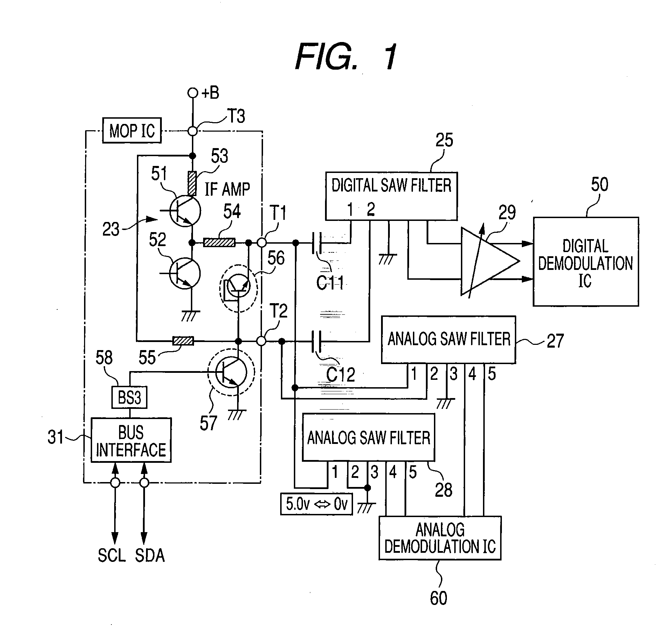

Fig. 1 is a circuit diagram mainly illustrating the circuit configuration for band switching of a digital SAW filter and an analog SAW filter for sound. Further, the television receiver according to the embodiment includes elements identical to those of the television receiver illustrated in Fig. 6, except for the circuit configuration for performing the band switching, and the same reference numerals are used to designate the same elements as those of Fig. 6 in order to avoid the redundancy.

The intermediate frequency amplifier 23 includes transistors 51 and 52, which are cascode-connected to each other, as main elements, and an IF signal is input to a base of the transistor 51. An IF signal having an inverted phase is input to a base of the transistor 52, so that drive capacity of the transistor 51 is corrected. The intermediate frequency amplifier 23 is a balance type amplifier and has the general circuit configuration illustrated in Fig. 6. That is, the intermediate frequency amplifier 23 includes two pairs of output circuits of the transistors 51 and 52 and transistors 61 and 62 (not shown). Further, in order to correct the drive capacity, IF signals having an inverted phase are input to the bases of the transistors 52 and 62. A collector of the transistor 51 located at a power supply side is connected to a power supply terminal T3, which serves as a supply terminal of a power supply voltage of an integrated circuit MOP IC, through a bias resistor 53. Further, an emitter of the transistor 52 located at a ground side is connected to the ground. Output of the intermediate frequency amplifier 23 is taken out from a connection point of an emitter of the transistor 51 and a collector of the transistor 52, and an output terminal T1 serving as a high frequency signal output terminal of the integrated circuit MOP IC is connected to the connection point through a bias resistor 54. The output terminal T1 of the integrated circuit MOP IC is connected to first terminals (first pins) of the digital SAW filter 25, the analog SAW filter 27 for sound and the analog SAW filter 28 for an image. Further, an output terminal T2 of the integrated circuit MOP IC is connected to second terminals (second pins) of the digital SAW filter 25 and the analog SAW filter 27 for sound. The power supply terminal T3 and the output terminal T2 of the integrated circuit MOP IC are connected to each other in a direct current manner through a bias resistor 55. In addition, the output terminals T1 and T2 of the integrated circuit MOP IC are connected to each other through a transistor 56 serving as a switching device. A base of the transistor 56 is connected to the output terminal T2, and the base and the collector of the transistor 56 are connected to each other. Further, an emitter of the transistor 56 is connected to the output terminal T1 in a direct current manner. In this way, the first and second terminals of the digital SAW filter 25 and the analog SAW filter 27 for sound are connected to each other through the transistor 56. Further, the output terminal T2 (base of the transistor 56) is connected to the ground through a collector-emitter of a transistor 57 serving as a switching device. A band switching signal of ON/OFF is input to a base of the transistor 57 serving as a control signal input terminal from a band switching port 58. The band switching port 58 is a port in which DC output (e.g., 5V or 0V) appears in response to a control signal supplied to a bus interface 31. The DC output of the band switching port 58 serves as the band switching signal. Similarly to the television receiver illustrated in Fig. 6, the band switching signal is controlled by the control signal supplied to the bus interface 31 from the host. The transistor 57 is turned on (conductive), so that the output terminal T2 (second terminals of the digital SAW filter 25 and the analog SAW filter 27 for sound) is grounded. Further, the transistor 56 is turned off (not conductive), so that a non-conductive state is established between the output terminals T1 and T2.

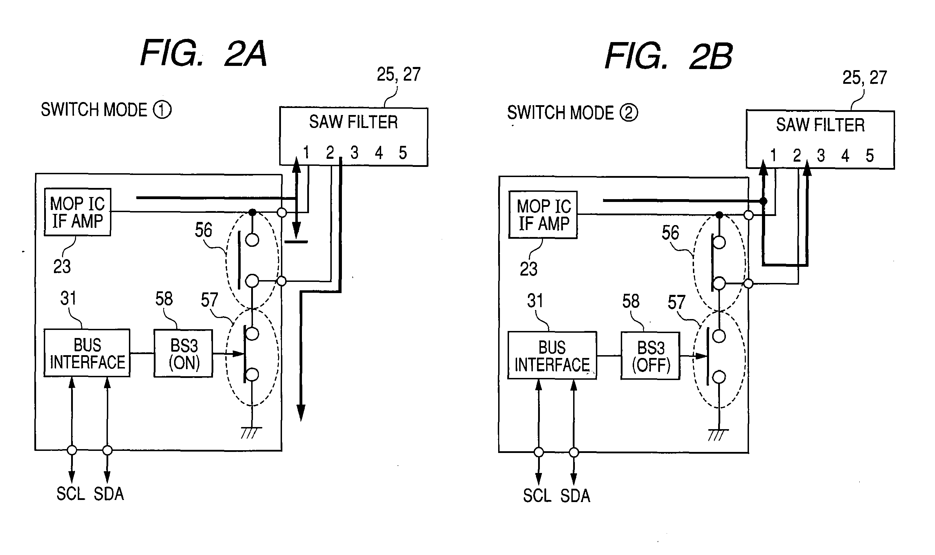

Figs. 2A and 2B are diagrams illustrating an operation example of band switching of the digital SAW filter 25 and the analog SAW filter 27 for sound according to the embodiment.

In the operation example of Fig. 2A, only the second terminals of the digital SAW filter 25 and the analog SAW filter 27 for sound are grounded. The control signal for turning on the transistor 57 is supplied to the bus interface 31 from the host. The band switching port 58 outputs the DC output corresponding to the control signal, which is instructed from the host, as the band switching signal. Herein, DC output of 5V is output to the base of the transistor 57 as the band switching signal, so that the collector-emitter of the transistor 57 is conducted. The transistor 57 is turned on by the DC 5V applied to the base thereof, so that the output terminal T2 of the integrated circuit MOP IC is grounded and the transistor 56 connected between the output terminals T1 and T2 is turned off. As a result, as illustrated in Fig. 2A, only the second terminals of the digital SAW filter 25 and the analog SAW filter 27 for sound are grounded.

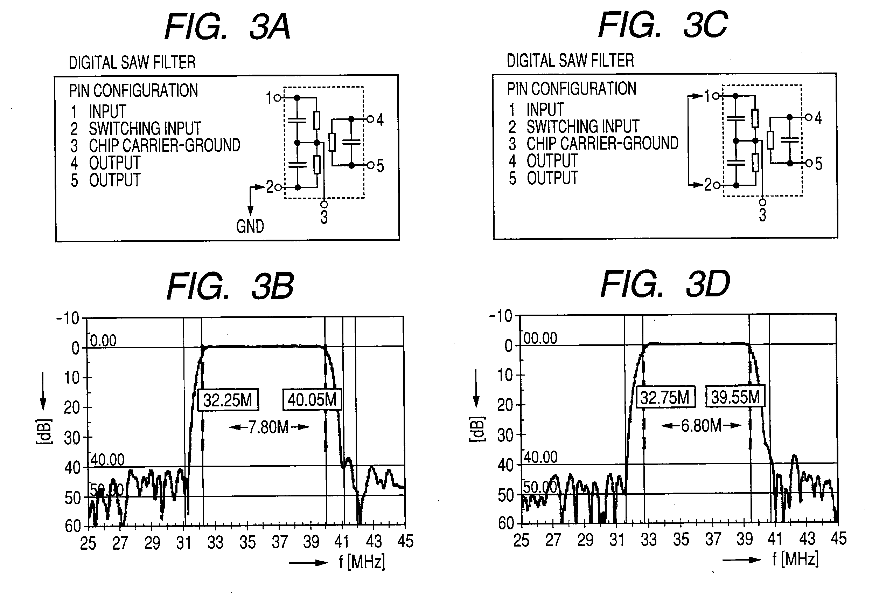

Fig. 3A illustrates the terminal configuration of the digital SAW filter 25 and the state in which the second terminal is grounded. Fig. 3B illustrates band characteristics set in the digital SAW filter 25 in the ground state illustrated in Fig. 3A. In the example, a pass band of 7.80MHz is set in the digital SAW filter 25.

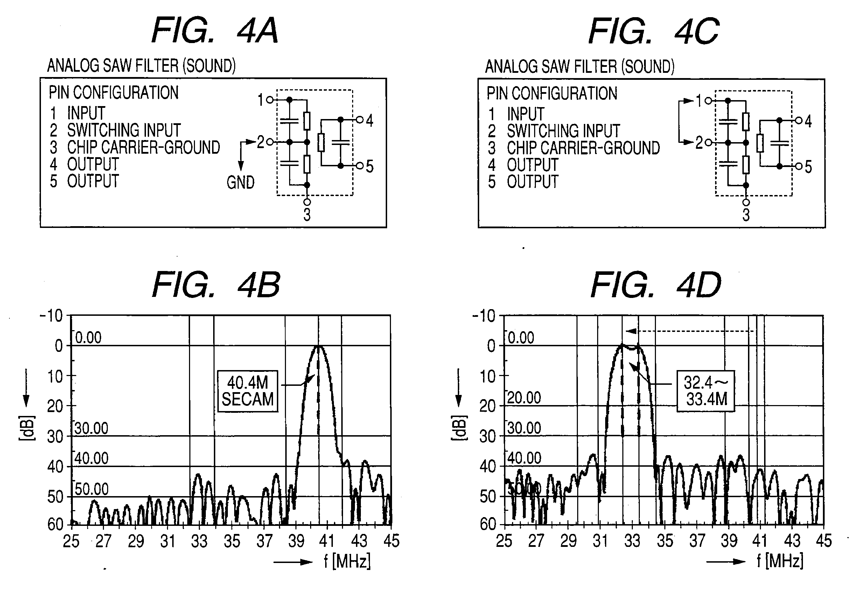

Fig. 4A illustrates the terminal configuration of the analog SAW filter 27 for sound and the state in which the second terminal is grounded. Fig. 4B illustrates band characteristics set in the analog SAW filter 27 for sound in the ground state illustrated in Fig. 4A. In the example, a narrow band, which has a center frequency of 40.4MHz, is set in the analog SAW filter 27 for sound.

In the operation example of Fig. 2B, the first and second terminals of the digital SAW filter 25 and the analog SAW filter 27 for sound are short-circuited. A control signal for turning off the transistor 57 is supplied to the bus interface 31 from the host. The control signal is received in the band switching port 58, and is output to the base of the transistor 57 as DC output of 0V that causes the collector-emitter of the transistor 57 to be non-conductive. The transistor 57 is turned off, so that the output terminal T2 of the integrated circuit MOP IC is switched to an open state from the ground state. Thus, the transistor 56 connected between the output terminals T1 and T2 is turned on by a bias voltage of the bias resistor 55. As a result, as illustrated in Fig. 2B, the first and second terminals of the digital SAW filter 25 and the analog SAW filter 27 for sound are short-circuited.

Fig. 3C illustrates the terminal configuration of the digital SAW filter 25 and the state in which the first and second terminals are short-circuited. Fig. 3D illustrates band characteristics set in the digital SAW filter 25 in the short-circuit state illustrated in Fig. 3C. In the example, a pass band of 6.80MHz is set in the digital SAW filter 25. That is, as compared with the band width set in the ground state of the second terminal illustrated in Fig. 3A, the bandwidth is reduced by IMHz.

Fig. 4C illustrates the terminal configuration of the analog SAW filter 27 for sound and the state in which the first and second terminals are short-circuited. Fig. 4D illustrates band characteristics set in the analog SAW filter 27 for sound in the short-circuit state illustrated in Fig. 4C. In the example, a narrow band, which has a center frequency of 32.4MHz to 33.4MHz, is set in the analog SAW filter 27 for sound. That is, the center frequency is shifted to a low frequency from 40.4MHz, which is set in the ground state of the second terminal illustrated in Fig. 4A, by 12 to 13MHz.

In this way, the control signal is supplied to the bus interface 31 from the host, so that the terminal states of input sections of the digital SAW filter 25 and the analog SAW filter 27 for sound are switched, thereby realizing band switching.

According to the embodiment as described above, since the output voltage of the intermediate frequency amplifier 23, which appears in the output terminal T1 of the integrated circuit MOP IC, becomes a reference potential of the transistor 56, the output circuit of the intermediate frequency amplifier 23 serves as a DC bias circuit of the transistor 56, so that it is possible to remove the DC bias circuit (DC cut capacitor C1 and resistors R1 and R2 of Fig. 8) which is necessary for the related art. According to the existing circuit illustrated in Figs. 6 and 8, since the potential difference occurs in the output voltage (output voltage of the intermediate frequency amplifier 23) of the integrated circuit MOP IC and the fixed bias by the resistors R1 and R2, dedicated bias circuits are necessary for the digital SAW filter 25 and the analog SAW filter 27 for sound. However, according to the embodiment, the output voltage of the intermediate frequency amplifier 23 serves as the reference potential of the transistor 56, so that RF switches can be unified in a digital/analog manner and the number of the RF switches can be reduced.

Further, according to the embodiment, the RF switches are unified in the digital/analog manner, control systems, which supply band switching instruction to the digital SAW filter 25 and the analog SAW filter 27 for sound, can be simplified through unification thereof.

Further, according to the embodiment, the DC switch, which generates the band switching signal, has a circuit configuration (transistor 57) with the function of "open" and "ground", the DC switch and the RF switch can be used in common.

Furthermore, according to the embodiment, the number of parts can be significantly reduced, so that the transistor 56 and the bias resistor 55 can be embedded in the integrated circuit MOP IC, and all circuit elements for band switching of the digital SAW filter 25 and the analog SAW filter 27 for sound can be incorporated in the integrated circuit MOP IC. In addition, interconnection work of the integrated circuit MOP IC and the SAW filters can be completed by merely connecting the first and second terminals of the digital SAW filter 25 and the analog SAW filter 27 for sound to the output terminals T1 and T2 of the integrated circuit MOP IC. Further, as compared with the related art, the number of work steps can be significantly reduced, and soldering places can be reduced, thereby achieving the improvement of reliability.

Moreover, the DC cut capacitors C11 and C12 are connected to the first and second terminals of the digital SAW filter 25, respectively. However, the DC cut capacitors C11 and C12 can be removed if the above configuration belongs to a DC range which does not cause any problems in the DC resistance of the digital SAW filter 25. Consequently, the first and second terminals of the digital SAW filter 25 and the analog SAW filter 27 for sound are directly connected to the output terminals T1 and T2 of the integrated circuit MOP IC, so that the interconnection work is extremely simplified.

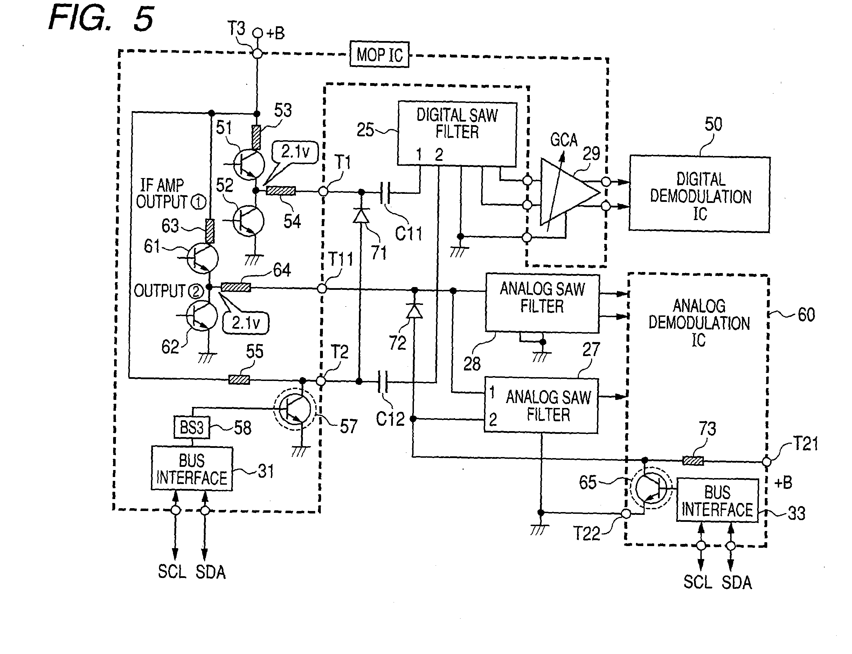

Fig. 5 is a circuit diagram illustrating the configuration of the rear-stage of the intermediate frequency amplifier in the television receiver according to a modification of the invention. The configuration of the pre-stage of the intermediate frequency amplifier in the television receiver is identical to that of the television receiver illustrated in Fig. 6.

The intermediate frequency amplifier including digital elements (transistors 51 and 52 and resistors 53 and 54) and analog elements (transistors 61 and 62 and resistors 63 and 64), which are provided in parallel to each other, is provided in the integrated circuit MOP IC. An output voltage of the analog intermediate frequency amplifier appears in an output terminal T11 of the integrated circuit MOP IC. Further, the gain control amplifier 29 connected to an output stage of the digital SAW filter 25 is embedded in the integrated circuit MOP IC.

In addition, a transistor 65 serving as an RF switch for band switching of an input section of the analog SAW filter 27 for sound is embedded in an analog demodulator 60. The transistor 65 has a collector connected to a DC power supply terminal T21 of the analog demodulator 60, and an emitter connected to a ground terminal T22 thereof.

A switch 71 provided in the form of a diode is connected between the first and second terminals of the digital SAW filter 25. A bias voltage is applied to an anode of the switch 71 through the bias resistor 55 and the anode is connected to the ground through the collector-emitter of the transistor 57.

Further, a switch 72 provided in the form of a diode is connected between the first and second terminals of the analog SAW filter 27 for sound. A bias voltage is applied to an anode of the switch 72 through a bias resistor 73 provided in the analog demodulator 60, and the anode is connected to the ground through the collector-emitter of the transistor 65 provided in the analog demodulator 60.

According to the modification having the above-described configuration, the switch circuit (transistor 57) having functions of "ground" and "open" is disposed in the integrated circuit MOP IC to which the output signal of the digital SAW filter 25 is input, the ground of the switch circuit (switch 71) of the input section of the digital SAW filter 25 and the ground of the integrated circuit MOP IC can be commonly used. In this way, an optimal arrangement is achieved, so that the original properties of the digital SAW filter 25 can be further realized.

In addition, the switch circuit (transistor 57) of the input section of the digital SAW filter 25 is disposed in the integrated circuit MOP IC in which the gain control amplifier 29 is embedded, so that a ground part of the digital SAW filter 25 and a ground part of the gain control amplifier 29 can be used in common, and the original transmission characteristics of the digital SAW filter 25 can be realized without being affected by the analog SAW filters 27 and 28.

Moreover, the switch circuit (transistor 65) of the input section of the analog SAW filter 27 for sound is disposed in the analog demodulator 60, so that a ground part of the analog SAW filter 27 for sound and a ground part of the analog demodulator 60 can be used in common, and the original transmission characteristics of the analog SAW filter 27 for sound can be realized without being affected by the digital SAW filter 25.

The invention is not limited to the above-described embodiment. The above description has been given based on the system of the television receiver. However, the invention can similarly be applied to a high frequency apparatus if the purpose is to switch connection states of first and second terminals in the high frequency apparatus.

The invention can be applied to a television receiver that performs a band switching operation by switching terminal connection states of the input sections of SAW filters in an intermediate frequency circuit.

It should be understood by those skilled in the art that various modifications, combinations, sub-combinations and alterations may occur depending on design requirements and other factors insofar as they are within the scope of the appended claims of the equivalents thereof.

## Claims

1. A high frequency apparatus comprising:
a first high frequency circuit (23) receiving a power supply voltage and having a high frequency signal output terminal;
a second high frequency circuit (25, 27) connected to the high frequency signal output terminal and having first and second switch terminals to perform switching to a first or a second operation mode according to a connection state of the first and second switch terminals;
a switch circuit interposed between the first high frequency circuit (23) and the second high frequency circuit (25, 27) to switch the connection state of the first and second switch terminals; and
a control circuit applying a control signal to the switch circuit,
wherein the switch circuit includes:
a first switching device (57) having a control signal input terminal receiving the control signal, a ground terminal connected to a ground, and an output terminal connected to a supply terminal (T3) of the power supply voltage through a resistor (55), and switching on/off between the output terminal and the ground terminal; and
a second switching device (56) having one end connected to the output terminal of the first switching device (57) and switching on/off between both ends of the second switching device (56),
wherein a constant voltage for switching on or off the first and second switching devices (57, 56) is output from the high frequency signal output terminal, and the other end of the second switching device (56) is connected to the high frequency signal output terminal in a direct-current manner.

2. The high frequency apparatus according to claim 1, wherein the first switch terminal is connected to the other end of the second switching device (56), the second switch terminal is connected to the output terminal of the first switching device (57), the second switching device (56) is switched off when the first switching device (57) is switched on, and the second switching device is switched on when the first switching device is switched off.

3. The high frequency apparatus according to claim 1 or 2, wherein an output stage of the first high frequency circuit (23) includes two transistors (51, 52) serially connected to the supply terminal of the power supply voltage and a ground, and the high frequency signal output terminal is connected to a connection point of the two transistors.

4. The high frequency apparatus according to any one of claims 1 to 3, wherein the second high frequency circuit (25, 27) is a SAW filter circuit which is in a first operation mode set to a first band characteristics when the first and second switch terminals are opened and the second switch terminal is grounded, and is in a second operation mode set to a second band characteristics different from the first band characteristics when the first and second switch terminals are short-circuited and the second switch terminal is opened with respect to the ground.

5. The high frequency apparatus according to any one of claims 1 to 4, wherein the first high frequency circuit (23) and the switch circuit are formed in a single integrated circuit.
